# EUROPEAN PATENT APPLICATION

(11) **EP 2 555 591 A1**
(43) Date of publication of application: **06.02.2013**
(21) Application number: 11759459.8
(22) Date of filing: 23.03.2011
(51) Int. Cl.: H05B 33/10, H01L 51/50, H05B 33/12, H05B 33/22

(54) **METHOD FOR MANUFACTURING LIGHT-EMITTING DEVICE**

(30) Priority: 26.03.2010 JP 2010071816
(71) Applicant: Sumitomo Chemical Company, Limited, Tokyo 104-8260 (JP)
(72) Inventor: GODA, Tadashi, Tsukuba-shi Ibaraki 305-0821 (JP)
(74) Representative: Jackson, Martin Peter
(86) International application number: PCT/JP2011/057033
(87) International publication number: WO 2011/118654

(57) **Abstract**

Provided is a method for manufacturing a light-emitting device in which an organic electroluminescent (EL) layer having an intended shape is formed. The method is, for manufacturing a light-emitting device (21) that includes a supporting substrate, a partition wall (17) that is provided on the supporting substrate and defines a concave portion (18) defined on the supporting substrate, and a plurality of organic EL elements (22) provided in the concave portion each element including a first electrode (12), a second electrode, and an organic EL layer provided between the first and the second electrodes; and the method includes the steps of: preparing the supporting substrate on which the first electrode and the partition wall are provided; supplying an ink including a material to be the organic EL layer to the concave portion, so as to be a volume of 90 percent or more and 120 percent or less relative to the capacity of the concave portion; solidifying the supplied ink to form the organic EL layer; and forming the second electrode.

## Description

### TECHNICAL FIELD

The present invention relates to a method for manufacturing a light-emitting device.

### BACKGROUND ART

There are various types of display devices, which have a different structure and principle. As one of these, at present, a display device in which an organic electroluminescent (organic EL) element (electroluminescent element) is used for a light source of a pixel is being put to practical use.

This display device is provided with a plurality of organic EL elements arranged on a supporting substrate. On the supporting substrate, a compartment in which the organic EL element is provided is defined, and on the supporting substrate, a partition wall is generally provided for defining a concave portion that corresponds to the compartment in which the organic EL element is provided. That is, the organic EL elements are each arranged in the concave portion defined by the partition wall.

An organic EL element is composed of a pair of electrodes and an organic EL layer interposed between the pair of electrodes, and is prepared by stacking the each component sequentially.

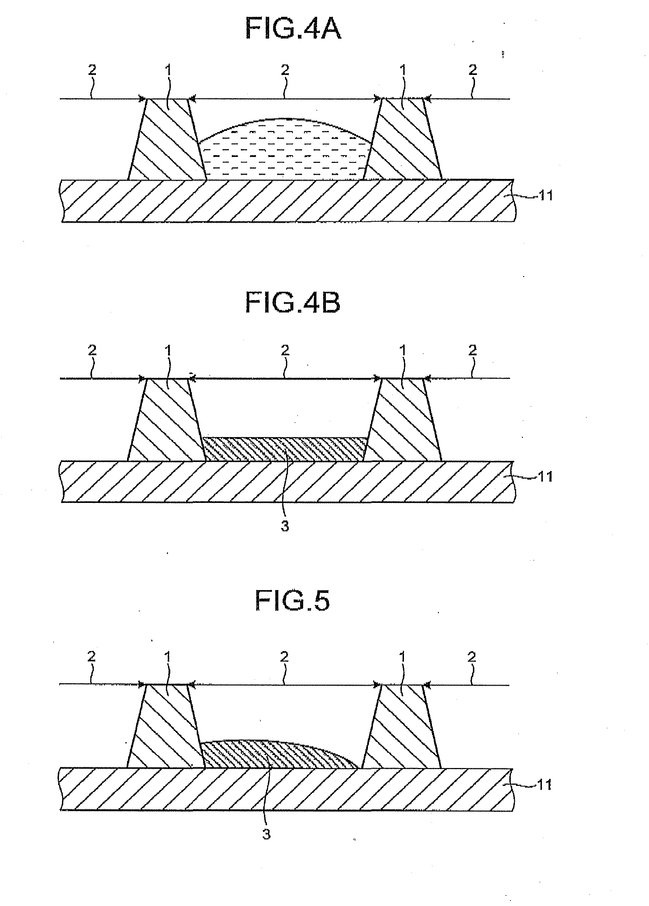

The organic EL layer that constitutes the organic EL element may be formed by a coating method. Embodiments for the case of forming an organic EL layer by a coating method are illustrated in Figures 4A and 4B. Figures 4A and 4B are the figures that illustrate an embodiment for forming an organic EL layer by a coating method.
As illustrated in Figure 4A, firstly, an ink including a material to be the organic EL layer is supplied to a concave portion 2 that is an area defined by partition wall 1 that are adjacent to each other on a supporting substrate 11. The supplied ink shrinks as it dries.
As the result, as illustrated in Figure 4B, an organic EL layer 3 is formed in the concave portion 2 (see Patent Document 1, for example).

### RELATED ART DOCUMENTS

Patent Document 1: JP 2002-75640 A

### DISCLOSURE OF INVENTION

### PROBLEM TO BE SOLVED BY THE INVENTION

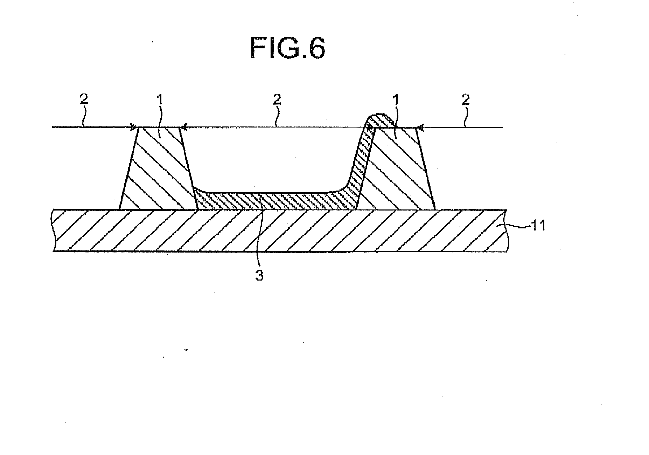

According to the above conventional technique, it is possible to form an organic EL layer in a concave portion by a coating method. However, in some cases, it is difficult to form an organic EL layer by a coating method so as to have an intended shape, and some organic EL layers having a defect could be formed.
Referring to Figures 5 and 6, a shape of the organic EL layer which is formed by a coating method is explained. Figures 5 and 6 are the figures that illustrate Schematically a display device in which an organic EL layer not having an intended shape is formed.
A film thickness of the organic EL layer 3 is preferably uniform for all over the layer. However, for example as illustrated in Figure 5, in some cases, an organic EL layer 3 could be formed, the film thickness of which is extremely thin at a vicinity of the boundary between the partition wall 1 and the organic EL layer 3. Such an organic EL layer 3 has a problem that an electrical resistance of a portion where the film thickness of the organic EL layer 3 is extremely thin becomes small and a leakage current is generated.

Further, as illustrated in Figure 6, the ink supplied to a concave portion 2 defined by the partition wall 1 dries while spreading in wet condition along the surface of the partition wall 1, and in some cases the organic EL layer 3 could be formed also over the side surface of the partition wall 1 as well. Moreover, in some cases, the ink could overflow the concave portion 2 into an adjacent concave portion 2 to mix with an ink that is to be supplied to the adjacent concave portion 2, resulting in a problem of cross-color contamination.

Therefore, a purpose of the present invention is to provide a method for manufacturing a light-emitting device, by which an organic EL layer having an intended shape can be formed.

The present invention provides the following [1] to [10].
[1] A method for manufacturing a light-emitting device comprising a supporting substrate, a partition wall that is provided on the supporting substrate and defines a concave portion, a plurality of organic electroluminescent elements provided in the concave portion, each element comprising a first electrode, a second electrode, and an organic electroluminescent layer provided between the first electrode and the second electrode, the method comprising the steps of:
   preparing the supporting substrate that is provided with the first electrode and the partition wall;
   supplying an ink that comprises a material to be the organic electroluminescent layer to the concave portion, so as to be the volume of 90 percent or more and 120 percent or less relative to a capacity of the concave portion;
   forming the organic electroluminescent layer by solidifying the supplied ink; and
   forming the second electrode.
[2] The method for manufacturing the light-emitting device according to [1],
   wherein the partition wall comprises a plurality of partition wall members extending in a line direction, respectively, and each of the partition wall members is disposed to a column direction different from the line direction at a prescribed interval.
[3] The method for manufacturing the light-emitting device according to [1] or [2],
   wherein a viscosity of the ink is 15 cP or more and 30 cP or less.
[4] The method for manufacturing the light-emitting device according to any one of [1] to [3],
   wherein a concentration of the ink is 10 mg/mL or more and 30 mg/mL or less.
[5] The method for manufacturing the light-emitting device according to any one of [1] to [4],
   wherein a contact angle between the partition wall and the ink is 5 degrees or more and 50 degrees or less.
[6] The method for manufacturing the light-emitting device according to [5],
   wherein an oxygen plasma treatment is carried out after the step of preparing the support substrate, and before the step of supplying the ink.
[7] The method for manufacturing the light-emitting device according to any one of [1] to [6],
   wherein a surface tension of the ink is 30 mN/m or more and 72 mN/m or less.
[8] The method for manufacturing the light-emitting device according to any one of [1] to [7],
   wherein the ink comprises a solvent that has a boiling point of 190 degrees Celsius or more and 260 degrees Celsius or less.
[9] The method for manufacturing the light-emitting device according to any one of [1] to [8],
   wherein, at the step of supplying, the ink is dropped in a liquid-column shape.
[10] The method for manufacturing the light-emitting device according to any one of [1] to [9],
   wherein, at the step of supplying, the ink is supplied by a nozzle printing method.

### EFFECT OF INTENTION

According to the present invention, an undesirable hole formation or undesirable cross-color contamination can be prevented, and a light-emitting device in which an organic EL layer having an intended shape is formed can be produced. Therefore, a light-emitting device in which an occurrence of defective element is suppressed can be produced.

### BRIEF DESCRIPTION OF DRAWINGS

Figure 1 is a plan view to illustrate schematically a light-emitting device of a present embodiment.
Figure 2 is a cross-sectional view to illustrate schematically a light-emitting device.
Figure 3 is a view to illustrate the evaluation result of a film formation.
Figure 4(A) is a view to illustrate an embodiment for forming an organic EL layer by a coating method.
Figure 4(B) is a view to illustrate an embodiment for forming an organic EL layer by a coating method.
Figure 5 is a view to illustrate schematically a display device in which an organic EL layer has a shape different from an intended shape is formed.
Figure 6 is a view to illustrate schematically a display device in which an organic EL layer has a shape different from an intended shape is formed.

### DESCRIPTION OF EMBODIMENTS

An embodiment of the present invention is explained below, referring to Figures. In the explanation below, the shapes, the sizes, and the arrangements of the components in each Figure are schematically illustrated to the extent of being able to understand the invention, and the present invention is not particularly limited by these. Further, in each Figure, the same components are illustrated with the same numeral and duplicate explanations will be omitted in some cases.
A method for manufacturing a light-emitting device of the present invention is the method for manufacturing a light-emitting device comprising a supporting substrate, a partition wall provided on the supporting substrate and defining a concave portion provided on the supporting substrate, a plurality of organic EL elements provided in the concave portion, each element comprising a first electrode, a second electrode, and an organic EL layer interposed between the first electrode and the second electrode, the method comprises the steps of: preparing the supporting substrate on which the first electrode and the partition wall are provided; supplying an ink comprising a material to be the organic EL layer to the concave portion, so as to be the volume of 90 percent or more and 120 percent or less relative to the capacity of the concave portion; forming the organic EL layer by solidifying the ink supplied; and forming the second electrode.

A light-emitting device is utilized as a display device, for example. As to the light-emitting device, an active matrix-driven type, and a passive matrix-driven type are included. The present invention can be applied to the either type of display devices. The present embodiment explains a light-emitting device that is applied to an active matrix-driven display device, as an example.

### <Composition of Light-Emitting Device>

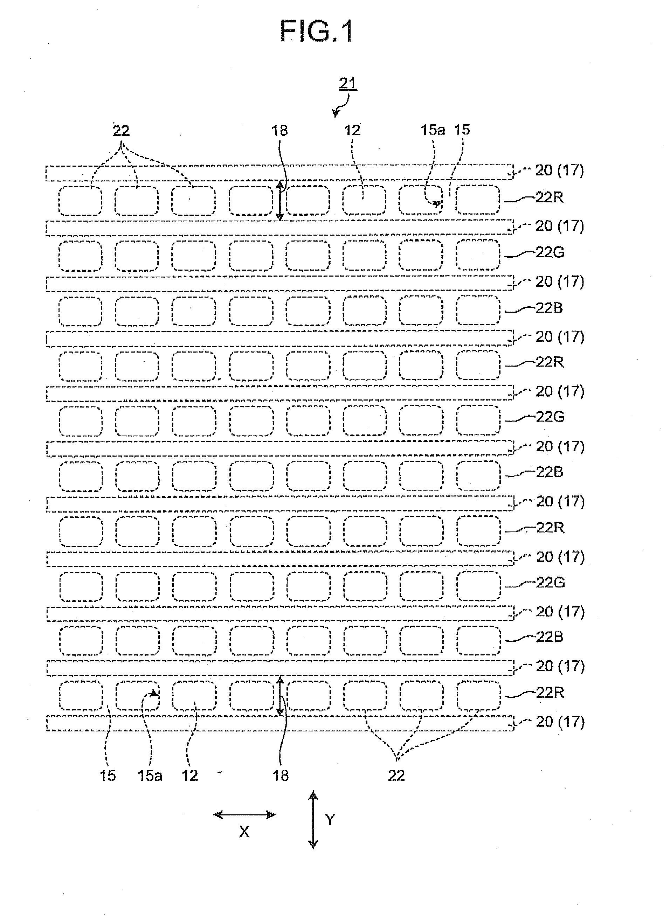

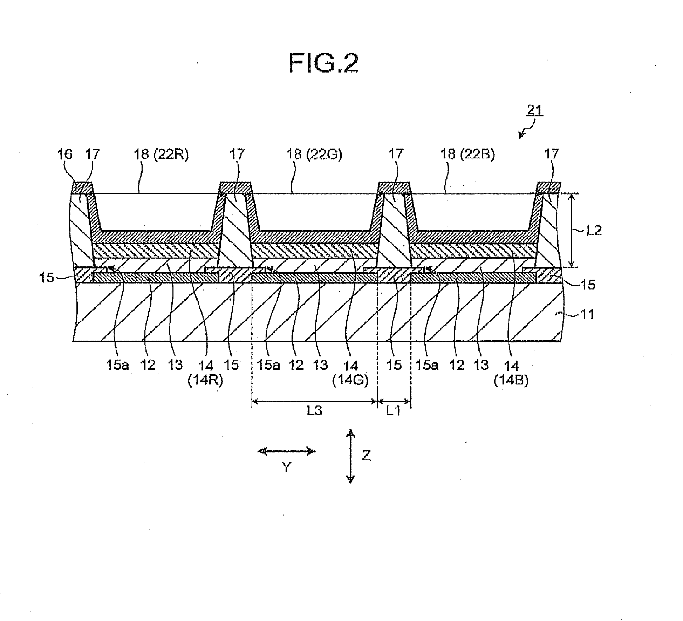

First, a composition of the light-emitting device is explained referring to Figures 1 and 2. Figure 1 is a plan view to illustrate schematically a light-omitting device of the present embodiment. Figure 2 is a cross-sectional view to schematically illustrate a light-emitting device.
A light-emitting device 21 primarily comprises: a supporting substrate 11; a partition wall 17 that is provided on the supporting substrate 11 and defines a concave portion 18 that is a compartment defined on the supporting substrate 11; a plurality of organic EL elements 22 (22R, 22G, 22B) provided in the concave portion 18. The organic EL element 22 is composed of a first electrode 12, a second electrode 16, a hole injection layer 13 and a light-emitting layer 14 (14R, 14G, 14B), and the hole injection layer 13 and the light-emitting layers are the organic EL layers provided between the first electrode 12 and the second electrode 16.

A plurality of the organic EL elements 22 are each arranged in the prescribed concave portion 18 that is defined on the supporting substrate 11. The partition wall 17 is provided to define the prescribed concave portion 18 that is defined on the supporting substrate 11, and a partition wall member 20 that constitutes the partition wall 17 has a shape that is designed in accordance with the shape of the concave portion 18 defined on the supporting substrate 11. For example, in the case that matrix-pattern concave portions 18 are defined on the supporting substrate 11, a grid-shape partition wall 17 for defining the matrix-pattern concave portions 18 is provided on the supporting substrate 11. In the case that stripe-pattern concave portions 18 are defined on the supporting substrate 11, stripe-pattern partition walls 17 for defining the stripe-pattern concave portions 18 are provided on the supporting substrate 11.
In the present embodiment, a light-emitting device in which the stripe-pattern partition walls 17 are provided on the supporting substrate 11 is explained. That is, the partition walls 17 of the present embodiment are composed of a plurality of partition wall members 20 each extending substantially parallel each other to a prescribed line direction X on the supporting substrate 11. The partition wall members 20 are disposed at a prescribed interval to a column direction Y that is different from the line direction X. The line direction X and the column direction Y of the present embodiment cross each other at right angles, and each crosses at right angles to a thickness direction Z of the supporting substrate 11- On the supporting substrate 11, a plurality of concave portions 18 that correspond to the spaces between the partition wall members 20 are defined.

In the present embodiment, an insulating film 15 is further provided between the supporting substrate 11 and the partition wall 17. The insulating film 15 is provided, for example, in order to ensure electrical insulation among the organic EL elements 22 that are adjacent to each other in the line direction X or in the column direction Y. The insulating film 15 of the present embodiment is formed in a grid shape. A grid-shape insulating film 15 is composed of a plurality of strip-pattern parts extending in the line direction X and a plurality of strip-pattern parts extending in the column direction Y to be formed integrally. In other words, the insulating film 15 is a thin film having an electrical insulating property which is provided with many openings 15a formed in a matrix.
The opening 15a of the insulating film 15 is formed at a position where the organic EL element 22 is overlapped as viewed from a thickness direction of the supporting substrate (hereinafter, also referred to as "in a planar view"). The opening 15a of the insulating film 15 is formed so as to almost coincide with the position of a first electrode 12 in a planar view as described below, and for example, is formed in a substantially rectangular shape, an oval shape, a substantially circular shape, a substantially elliptical shape, or a similar shape. The grid-shape insulating film 15 is formed so as to expose a part of the first electrode 12 in a planar view, and thus the part of the insulating film 15 covers the periphery of the first electrode 12. Further, the partition wall members 20 described above are provided on the strip-pattern parts of the insulating film 15.

The organic EL element 22 is provided in the concave portion 18 defined by the partition wall 17. In the present embodiment, a plurality of the organic EL elements 22 are provided between the partition wall members 20 that are adjacent to each other in the column direction Y (that is, these are provided in the concave portions 18) so as to be disposed at a prescribed interval in the line direction X. That is, in the present embodiment, a plurality of the organic EL elements 22 are arranged in a matrix pattern on the supporting substrate 11, and are arranged at a prescribed interval to the line direction X and also at a prescribed interval to the column direction Y. Further, it is not necessary that organic EL elements 22 are physically apart from each other, and it is sufficient that they are electrically insulated each other so as to be driven individually. For this reason, some of the layers (the first electrode 12, a second electrode 16, and the organic EL layer) that form the organic EL element 22 may be physically connected to the other organic EL elements 22.

The organic EL element 22 is composed of the first electrode 12, organic EL layers (a hole injection layer 13 and a light-emitting layer 14), and the second electrode 16, which are arranged in this order in a way that the first electrode 12 is closer to the supporting substrate 11.

The first electrode 12 and the second electrode 16 constitute a pair of electrodes composed of an anode and a cathode. That is, one of the first electrode 12 and the second electrode 16 is provided as the anode while the other is provided as the cathode. The first electrode 12 of the first electrode 12 and the second electrode 16 is disposed to be closer to the supporting substrate 11, while the second electrode 16 is disposed apart from the supporting substrate 11, than the first electrode 12.

An organic EL element 22 has one or more organic EL layers. The organic EL layer refers to any layers including an organic material and being interposed between the first electrode 12 and the second electrode 16. The organic EL element has at least one or more light-emitting layers 14 as an organic EL layer. Between the first electrode 12 and the second electrode 16, not only the light-emitting layer 14, a prescribed layer is provided as necessary. For example, between the anode and the light-emitting layer 14, a hole injection layer, a hole transport layer, an electron block layer and the like are provided as the organic EL layer, while between the light-emitting layer 14 and the cathode, a hole block layer, an electron transport layer, an electron injection layer and the like are provided as the organic EL layer.

The organic EL element 22 of the present embodiment is provided with the hole injection layer 13 between' the first electrode 12 and the light-emitting layer 14, as an organic EL layer.

As an embodiment, an organic EL element 22 is explained below, in which a first electrode 12 that works as an anode, a hole injection layer 13, a light-emitting layer 14, and a second electrode 16 that works as a cathode, are stacked in this order in a way that the first electrode 12 is closer to a supporting substrate 11.

The light-emitting device 21 of the present embodiment is an active matrix-driven type; therefore, the first electrode 12 is provided to each organic EL element 22. That is, as many first electrodes 12 as the organic EL elements 22 are provided on the supporting substrate 11. The first electrode 12 is, for example, a thin film that is formed to be substantially rectangular in a planar view. The first electrodes 12 are provided in a matrix pattern on the supporting substrate 11, corresponding to the positions where the organic EL elements 22 are provided. The first electrodes 12 are disposed at a prescribed interval to the line direction X and also at a prescribed interval to the column direction Y. Further, the first electrodes 12 are provided between the partition wall members 20 that are adjacent to each other in the column direction Y in a planar view, and are arranged remaining a prescribed interval to the line direction X in each space between the partition wall members 20.

As described above, a grid-shape insulating film 15 is formed so as to expose a part of the first electrode 12 in a planar view, and thus the part of the insulating film 15 covers the periphery of the first electrode 12. That is, the insulating film 15 has an opening 15a so as to expose a part of the first electrode 12.

The hole injection layer 13 is disposed so as to extend in the line direction X in the concave portion 18 that is sandwiched between the adjacent partition wall members 20. That is, the hole injection layers 13 are formed in a strip pattern in the concave portions 18 defined by the partition wall members 20 that are adjacent each other in the column direction Y, and continuously are formed across over the organic EL elements 22 that are adjacent each other in the line direction X.

The light-emitting layer 14 is disposed in an area that is sandwiched between the partition wall members 20 adjacent each other, so as to extend in the line direction X. That is, the light-emitting layers 14 are formed in a strip pattern in the concave portions 18 defined by the partition wall members 20 that are adjacent each other in the column direction Y, and continuously are formed across over the organic EL elements 22 that are adjacent each other in the line direction X. The strip-pattern light-emitting layers 14 are stacked on the strip-shape hole injection layers 13.

An organic EL element of the embodiments of the' present invention can be applied to a monochrome display device. However, in the present embodiment, an application to a color display device is explained. In a color display device, three kinds of organic EL elements each of which emits light of either red, green, or blue are provided on the supporting substrate 11. The color display device may be made, for example, by repeatedly arranging the following lines (I), (II), and (III) in this order in the column direction Y.

(I) A line on which a plurality of organic EL elements 22R that emit red light are disposed at a prescribed interval in the line direction X.
(II) A line on which a plurality of organic EL elements 22G that emit green light are disposed at a prescribed interval in the line direction X.
(III) A line on which a plurality of organic EL elements 22B that emit blue light are disposed at a prescribed interval in the line direction X.

Thus, in the case of forming the three kinds of organic EL elements each of which emits light having a different color, a light-emitting layer that emits light having a different color is usually provided for each type of element. In the present embodiment, the following lines (i), (ii), and (iii) are repeatedly arranged in this order in the column direction Y.

(i) Line on which a light-emitting layer 14R that emits red light is provided.
(ii) Line on which a light-emitting layer 14G that emits green light is provided.
(iii) Line on which a light-emitting layer 14B that emits blue light is provided.

In this case, each of the three kinds of strip-shape light-emitting layers 14 (14R, 14G, 14B) extending in the line direction X is sequentially stacked on the hole injection layer 13 so as to be arranged with a space of two lines in the column direction Y.

The second electrode 16 is provided on the light-emitting layers 14. Further, in the present embodiment, the second electrode 16 is continuously formed across over the organic EL elements 22 arranged in a matrix pattern and serve as an electrode common to a plurality of the organic EL elements 22. The second electrode 16 is formed not only over the light-emitting layers 14, and also on the partition walls 17 so that the electrodes on the light-emitting layers 14 and the electrodes on the partition walls 17 are linked.

### <Method for Manufacturing Light-Emitting Device>

Next, a method for manufacturing a light-emitting device is explained.

### (step of Preparing Supporting Substrate)

In this step, a supporting substrate 11 on which a first electrode 12 and a partition wall 17 are provided is prepared. In the case of an active matrix-driven display device, a substrate on which a circuit for individually driving a plurality of organic EL elements 22 is preformed may be used as the supporting substrate 11. For example, a substrate on which a thin film transistor (TFT), a capacitor, and the like are preformed may be used as the supporting substrate 11. The substrate on which a first electrode 12 and a partition wall 17 are provided may be prepared as the supporting substrate 11 by forming the first electrode 12 and the partition wall 17 in this step as follows. Alternatively, a substrate on which a first electrode 12 and a partition wall 17 are preformed may also be commercially obtained for using as the supporting substrate 11.

The first electrodes 12 are formed in a matrix on the supporting substrate 11. The first electrode 12 is formed, for example, by forming a conductive thin film on all over the supporting substrate 11, and then patterning the conductive thin film in a matrix-pattern by photolithography (in the following description, "photolithography" includes a patterning step such as an etching step performed following a mask pattern-forming step). Alternatively, the first electrode 12 may also be patterned, for example, by disposing on the supporting substrate 11 a mask in which an opening is formed at a prescribed area, and then selectively depositing a conductive material through the mask only on a prescribed area on the supporting substrate 11. A material for the first electrode 12 is described below.

Next, the partition wall 17 is formed on the supporting substrate 11. In the present embodiment, the partition wall 17 composed of a plurality of partition wall members 20 is formed. The partition wall 17 is made of an organic substance or an inorganic substance. Examples of the organic substance that constitutes the partition wall 17 may include resins such as an acrylic resin, a phenol resin, and a polyimide resin. Examples of the inorganic substance that constitutes the partition wall 17 may include SiOₓ, SiNₓ and the like. The partition wall 17 is preferably made of an organic substance. The partition wall 17 has preferably lyophobicity in order to hold an ink to be supplied to the concave portion 18 defined (encircled) by the partition wall 17, within the concave portion 18. Organic substances generally have more lyophobicity to an ink than inorganic substances, and therefore by making the partition wall 17 with an organic substance, the performance to hold an ink within the concave portion 18 is enhanced.

In the case of forming the partition wall 17 made of an organic substance, for example, a positive or a negative photosensitive resin is applied to the supporting substrate 11, and then exposure is performed on a prescribed area, followed by development and curing to form a plurality of partition wall members 20, that is the partition wall 17. As the photosensitive resin, a photoresist may be used. In the case of forming the partition wall 17 made of an inorganic substance, for example, a thin film made of an inorganic substance is formed on the supporting substrate 11 by a plasma CVD method, a sputtering method, or a similar method, and then a prescribed area in the thin film is removed and a plurality of partition wall members 20 are formed. The prescribed area is removed by photolithography, for example.

In the case of manufacturing the light-emitting device 21 comprising a grid-shape insulating film 15, the insulating film 15 is formed before the step of forming the partition wall 17. The insulating film 15 may be formed in a grid shape by using, for example, the material described in the above as the material for the partition wall 17, in the same manner as in the formation of the partition wall 17.
In the present embodiment, the grid-shape insulating film 15 and the partition wall 17 are sometimes explained as an integral composition. In the following description, "then concave portion 18 defined by the partition wall 17" sometimes refers to an area that is defined (surrounded) by the insulating film 15, the partition wall 17, and the supporting substrate 11 or a surface (bottom plane) exposed between the partition walls 17 that are adjacent to each other.

In the case of forming the insulating film 15 in addition to the partition walls 17, the insulating film 15 is preferably made of an inorganic substance having more lyophilicity than an organic substance. This is because, when the insulating film shows lyophobicity, in some cases, an ink supplied to the concave portion 18 defined by the partition walls 17 could dry while the ink is repelled from the insulating film 15, and thus the presence of an insulating film 15 could affect uniformity of the organic EL layer, resulting in not obtaining a uniform organic EL layer in some cases.

A shape and an arrangement of the partition walls 17 are appropriately designed depending on the specification of a display device such as the number of pixels and revolution, ease of production, and the like. For example, a width L1 of the partition wall member 20 in the column direction Y is about 5 µm to 50 µm. A height L2 of the partition wall member 20 is about 0.5 µm to 5 µm. An interval L3 between the partition wall members 20 that are adjacent each other in the column direction Y, that is a width L3 of the concave portion 18 in the column direction Y, is about 10 µm to 200 µm. A width of the first electrode 12 in the line direction X or in the column direction Y is about 10 µm to 400 µm.

### (Step of Forming Organic EL Layer)

In the present step, first, an ink including a material to be an organic EL layer is supplied to the concave portion 18 defined by the partition wall 17. In the present embodiment, an ink including a material to be a hole injection layer 13 corresponding to the organic EL layer is supplied to the concave portion 18 defined by the partition wall 17.

A method for supplying the ink may include any coating method by which the ink can be selectively supplied to an area between the partition wall members 20 that are adjacent each other. Such methods include a method of intermittently dropping an ink, a method of discharging a liquid-columnar ink, a method of printing with an ink adhering on a printing plate, and the like. In the method of intermittently dropping an ink, liquid drops that are adhered to an ink adhering point may make a space between the ink adhering points in some cases, as the result, the space could cause a degradation of a uniformity of a film thickness. In the method of using a printing plate, it is necessary to accurately set a position of the printing plate and a subject, and thus it is difficult to supply an ink to a large area as intended. However, none of these problems essentially occur in a method of continuously discharging an ink, and therefore as a method for supplying the ink, the method of discharging a liquid-columnar ink is preferred among the above described methods. A preferred method of supplying an ink by discharging a liquid-columnar ink is a nozzle printing method by which an ink is supplied through a nozzle in a liquid-column state. The method of intermittently dropping an ink may include an ink jet printing method; and the method of printing with an ink that is adhered to a printing plate may include a letterpress printing method and an intaglio printing method.

In the nozzle printing method, an ink is continuously supplied to each line (concave portions 18) by one-stroke sketch, That is, a nozzle disposed over the supporting substrate 11 reciprocates to the line direction X while discharging a liquid-columnar ink through the nozzle, and at the turn of the reciprocation of the nozzle, the supporting substrate 11 is moved by only one line to the column direction Y, thereby supplying the ink to each line. For example, the supporting substrate 11 is moved by only one line to the column direction Y at the turn of reciprocation of the nozzle; thereby, the ink can be supplied to all the lines.

More specifically, the following steps (1) to (4) may be repeated in this order while discharging a liquid columnar-ink through a nozzle, and thereby the ink can be supplied to all the-areas (concave portions 18) between the partition wall members 20 that are adjacent each other.
(1) Step of moving a nozzle from one end in the line direction X toward the other end.
(2) Step of moving a supporting substrate 11 by one line to a column direction Y.
(3) Step of moving the nozzle from the other end in the line direction X toward the one end.
(4) step of moving the supporting substrate by one line to a column direction Y.

In the present step, an ink is supplied in a volume of 90 percent or more and 120 percent or less relative to the capacity of the concave portion 18 that is an area defined by the partition wall 17. Here, "the capacity of the concave portion 18" (sometimes referred to as a capacity defined by the partition walls 17, as well) means a capacity of a space that is defined by: a plane defined by top planes or ridges corresponding to the uppermost points of the adjacent partition wall members 20 in a cross section of the column direction Y; side surfaces of the partition wall members 20 facing each other (and an exposed surface of the insulating film 15); a plane defined by connecting each end of the partition wall members 20 facing each other in a longitudinal direction; and an exposed surface between the side surfaces of the partition wall members 20 facing each other. A shape of a.cross section of the partition wall member 20 in the column direction Y is illustrated as a trapezoid in Figure 2, while a cross section of the partition wall member 20 usually has a domical shape formed by a curve. When the partition wall member 20 has a domical cross section, a capacity of the concave portion 18 is corresponding to the capacity of "the concave portion 18" having a top plane defined by a plane connecting the ridges of the adjacent partition wall members 20.
Further, a volume of the ink to be supplied is preferably equivalent to 90 percent or more and 118 percent or less of the capacity of the concave portion 18.

When an amount of the ink supplying is too small relative to the capacity of the concave portion 18 defined by the partition wall 17, in some cases the ink supplying could not completely wet and spread over the bottom plane of the concave portion 18, resulting in forming a hole in the organic EL layer. On the other hand, when an amount of the ink supplying is too large relative to the capacity of the concave portion 18 defined by the partition wall 17, in some cases the ink supplied to a prescribed concave portion 18 could overflow the partition wall member 20 into an adjacent concave portion 18. Contrary to these, when an ink is supplied in a volume of 90 percent or more and 120 percent or less relative to the capacity of the concave portion 18, the ink wets and spreads over the bottom plane of the concave portion 18, thereby forming an organic EL layer (the hole injection layer 13 in the present embodiment) with no hole, and at the same time, an ink can be prevented from overflowing into an adjacent concave portion 18, thereby forming the organic EL layer only in the concave portion 18 to which the ink is supplied.

A hole injection layer 13 equivalent of the organic EL layer is formed by solidifying the ink supplied to the concave portion 18 that is an area between the partition wall members 20 adjacent each other. Solidifying the ink may be performed by removing a solvent, for example. The solvent may be removed by air drying, heat drying, vacuum drying, or the like. When the ink used includes a material that is polymerized with energy applied thereto such as light and heat, the hole injection layer 13 may be solidified by applying energy such as light and heat thereto after the ink is supplied.

### (Step of Forming Light-Emitting Layer)

Next, a light-emitting layer 14 is formed. As described above, in manufacturing a color display device, it is necessary to make three kinds of the organic EL elements 22. In order to perform this, each line is necessary to be applied in a different color by using a material for the each light-emitting layer. For example, when three types of light-emitting layers 14(14R, 14G, 14B) are formed respectively for each line, it is necessary to apply a red ink including a material emitting red light, a green ink including a material emitting green light, and a blue ink including a material emitting blue light, to each column with an interval of two column in the column direction Y. Then, by applying the red ink, the green ink, and the blue ink sequentially to a prescribed line respectively, the three kinds of the light-emitting layers 14 may be applied to be formed in a film. As a method of sequentially applying the red ink, the green ink, and the blue ink to a prescribed line, any coating methods may be applied by which an ink may be selectively supplied to the concave portion 18 that is an area between the partition wall members 20. Example of the method includes a method of intermittently dropping an ink, a method of discharging a liquid-columnar ink, a method of printing with an ink adhering on a printing plate, and the like. In the present embodiment, the method of discharging a liquid-columnar ink is preferable, as described above. For example, as in the method for forming a hole injection layer described above, an ink may be applied by a nozzle printing method that is one method of discharging a liquid-columnar ink.

More specifically, while discharging a liquid columnar red ink through a nozzle, the steps (1) to (4) may be performed repeatedly in this order, and thereby the red ink can be supplied to an area (concave portion 18) that is between, the partition wall members 20 by having an interval of two lines in the column direction Y.
(1) Step of moving the nozzle in the line direction X from one end of the concave portion 18 toward the other end.
(2) Step of moving the supporting substrate 11 by three lines to a column direction Y.
(3) Step of moving the nozzle in the line direction X from the other end of the concave portion 18 toward one end.
(4) Step of moving the supporting substrate by three lines to a column direction Y.

By supplying the green ink and the blue ink respectively in the same manner as the red ink supplying described above, the green ink and the blue ink may be supplied respectively to an area (concave portion 18) that is between the partition wall members 20 by having an interval of two lines in the column direction Y.

In the present step, an ink is supplied in a volume of 90 percent or more and 120 percent or less relative to the capacity of the concave portion 18 defined by the partition wall 17. The ink in the present step corresponds to the red ink, the blue ink, and the green ink. By controlling an amount of the ink to be supplied within this range, the ink wets and spreads over the bottom plane of the concave portion 18, thereby forming an organic EL layer (the light-emitting layer 14 of the present embodiment) with no hole can be formed, and at the same time, the ink can be prevented from overflowing into an adjacent concave portion 18, thereby forming the organic EL layer only in the concave portion 18 where the ink is supplied.

In the step of forming a hole injection layer 13 as described above, one kind of an ink is supplied to each line that is, to all of the concave portions 18; therefore, even when the ink overflows the partition wall 17 into an adjacent concave portion 18, it is nothing more than that the inks of the same kind mix together. On the other hand, when a plurality of concave portions 18 are applied with different kinds of inks such as the red ink, the blue ink, and the green ink, in some cases, the ink that overflows the partition wall 17 into an adjacent concave portion 18 could cause mixing the different kinds of inks together, and light-emitting properties such as light emitting color and luminous efficiency could be significantly affected thereby. In the present embodiment, however, by controlling an amount of the ink to be supplied, different kinds of inks can be prevented from mixing together in the concave portion 18, and therefore degradation in the light-emitting properties can be prevented.

A light-emitting layer is formed by solidifying the ink supplied to an area between the partition wall members 20. Solidifying the ink may be performed by removing a solvent, for example. The solvent may be removed by air drying, heat and drying, vacuum drying, or the like. When the ink used includes a material that is polymerized with energy applied thereto such as light and heat, the light-emitting layer may be solidified by applying energy such as light and heat thereto after the ink is supplied.

After forming the light-emitting layer 14, a prescribed organic layer or inorganic layer, or the like is formed by a prescribed method, if necessary. The layers to be provided as necessary may be formed by a prescribed coating method such as a printing method, an ink-jet printing method, and a nozzle printing method, or by a prescribed dry process.

### (Step of Forming Second Electrode)

Next, a second electrode 16 is formed. As described above, in the present embodiment, the second electrode 16 is formed all over the supporting substrate 11. Thus, a plurality of the organic EL elements 22 may be formed on the supporting substrate 11.

The ink used in the step of forming the organic EL layers (the hole injection layer 13 and the light-emitting layer 14 of the present embodiment) preferably has a viscosity of 15cP or more and 30cP or less. When a viscosity of the ink is too low, the ink supplied to the concave portion 18 could overflow the partition wall member 20 into an adjacent concave portion 18 in some cases. On the other hand, when a viscosity of the ink is too high, discharging the ink through a nozzle could be poor in some cases. By using an ink having a viscosity of 15cP or more and 30cP or less, the ink supplied to the concave portion 18 can be prevented from overflowing the partition wall 17 into an adjacent concave portion 18, and poor discharge of the ink can also be prevented.

The ink used in the step of forming the organic EL layers (the hole injection layer 13 and the light-emitting layer 14) preferably has a concentration of 10 mg/mL or more and'30 mg/mL or less. This is because when an ink concentration is too high, this could lead to ink gelation or precipitation of a solid content in the ink in some cases.

A film thickness of the organic EL layer is principally defined by a concentration of the ink and an amount of the ink supplied. Usually, an optimum film thickness of the organic EL layer is predetermined, and therefore a concentration of the ink and an amount of the ink to be supplied are determined by an inverse operation based on a value of the optimum film thickness of the organic EL layer. In the present embodiment, an ink is supplied in a volume of 90 percent or more and 120 percent or less relative to the capacity of the concave portion 18 the area of which is defined by the partition wall 17, and therefore an amount of the ink supplied is principally determined by a height (the maximum height) of the partition wall 17. Thus, when a concentration of the ink is 10 mg/mL or more and 30 mg/mL or less, a height of the partition wall 17 falls within a prescribed range.
When a concentration of the ink is low, in order to obtain an organic EL layer having a prescribed film thickness, it is necessary that an amount of the ink to be supplied is increased and therefore a height of the partition wall 17 is increased. As the result, when the ink is supplied in a volume of 90 percent or more and 120 percent or less of the capacity of the concave portion 18 defined by the partition wall 17, an area where the ink contacts to a surface of the partition wall 17 becomes large. The ink shrinks to form a thin film as the solvent vaporizes, and the shrinkage occurs during moving on the surface of the partition wall 17. Therefore, when an area where the ink contacts to the surface of the partition wall 17 becomes large, an influence of a surface property of the partition wall 17 is exerted; as the result, an organic EL layer having a uniform film thickness could not be obtained in some cases. Contrary to this, when an ink having a concentration of 10 mg/mL or more and 30 mg/mL or less is used, a partition wall 17 having an appropriate height can be used. As the result, the area where the ink contacts to the partition wall 17 can be made to be relatively small, and therefore an influence of the surface property of the partition wall 17 can be decreased when forming a thin film, resulting that an organic EL layer having a uniform film thickness can be obtained.

The partition wall 17 preferably has a contact angle of 5 degrees or more and 50 degrees or less, to the ink supplied. When a contact angle between the partition wall 17 and the ink is too small, in some cases, the ink could wet and spread over the surface of the partition wall 17, and then the ink supplied to the concave portion 18 could overflow the partition wall member 20 into an adjacent concave portion 18. In order to hold the ink supplied to the concave portion 18 within the prescribed concave portion 18, the partition wall 17 preferably has repellency. However, in order to increase a contact angle between the partition wall 17 and the ink, a treatment of providing repellency is required to the partition wall 17, and thus the number of steeps is increased. For example, plasma treatment in CF₄ gas is required to be performed in order to increase a contact angle between the partition wall 17 and the ink supplied. In addition, when a treatment for the repellency is performed, in some cases, an intended contamination could be caused by a foreign substance, and thus the properties of the organic EL element could be degraded. Therefore, by selecting a concentration of the ink, a solvent in the ink, and a material for the partition wall, and further achieving a contact angle between the partition wall 17 and the ink with 5 degrees or more and 50 degrees or less, the ink can be prevented from overflowing, and also an increase of the number of steps and degradation of the element properties can be suppressed.

The ink used in the step of forming the organic EL layer (the hole injection layer 13 and the light-emitting layer 14) preferably has a surface tension of 30 mN/m or more and 72 mN/m or less. When a surface tension of the ink is too low, the ink supplied to the concave portion 18 could overflow the partition wall member 20 into an adjacent concave portion 18 in some cases. However, by using an ink having a high surface tension, the ink can be prevented from overflowing the partition wall member 20 into an adjacent concave portion 18. A surface tension of the ink is preferably as high as possible, and it is not necessary to set a specific upper limit thereto. A surface tension of the ink is generally 72 mN/m or less.

The ink used in the step of forming an organic EL layer (a hole injection layer 13 and a light-emitting layer 14) preferably includes a solvent having a boiling point of 190°C or more and 260°C or less. A solvent having a high boiling point is difficult to evaporate, and therefore using a solvent having such a property that a boiling point of solvent is high, can delay a drying rate of the ink supplied to the concave portion 18. As the result, the duration time of solidifying the ink can be maintained longer. Thus, by maintaining the ink into a liquid state longer, a concentration of the ink and a height of the ink liquid level in the concave portion 18 can be made uniform. Therefore, an organic EL layer having a uniform film thickness can be obtained. A proportion of the solvent having a boiling point of 190°C or more and 260°C or less in the ink is preferably 10 percent by weight or more and 70 percent by weight or less, and is further preferably 40 percent by weight or more and 60 percent by weight or less.

A surface tension and viscosity of the ink may be adjusted by controlling a concentration of a material for an organic EL layer (a solid content) and selecting the type of the solvent. A composition of the ink and properties thereof change over time as it forms a thin film-A composition and properties of the ink described in the above mean the composition and the properties of the ink at the time of discharging the ink. As the solvent for the ink, one type of a solvent having a prescribed boiling point may be used alone, or a plurality of types of the solvents may be combined for use.
Examples of the solvent for the ink may include: aliphatic chlorine solvents such as chloroform (boiling point: 61°C), methylene chloride (boiling point: 40°C), 1,1-dichloroethane (boiling point: 57°C), 1,2-dichloroethane (boiling point: 83°C), 1,1,1-trichloroethane (boiling point: 74°C), and 1,1,2-trichloroethane (boiling point: 113°C); aromatic chlorine solvents such as chlorobenzene (boiling point: 132°C), o-dichlorobenzene (boiling point: 180°C), m-dichlorobenzene (boiling point: 173°C), and p-dichlorobenzene (boiling point: 174°C); aliphatic ether solvents such as tetrahydrofuran (boiling point: 66°C) and 1,4-dioxane (boiling point: 101°C); aromatic ether solvents such as anisole (boiling point: 154°C) and ethoxybenzene (boiling point: 170°C); aromatic hydrocarbon solvents such as toluene (boiling point: 111°C), o-xylene (boiling point: 144°C), m-xylene '(boiling point: 139°C), p-xylene (boiling point: 138°C), ethylbenzene (boiling point: 136°C), p-diethylbenzene (boiling point: 184°C), mesitylene (boiling point: 211°C), n-propylhenzene (boiling points: 159°C), isopropylbenzene (boiling point: 152°C), n-butylbenzene (boiling point: 183°C), isobutylbenzene (boiling point: 173°C), sec-butylbenzene (boiling point: 173°C), tetralin (boiling point: 208°C), and cyclohexylbenzene (boiling point measured at 737 mmHg: 235°C); aliphatic hydrocarbon solvents such as cyclohexane (boiling point: 81°C), methylcyclohexane (boiling point: 101°C), n-pentane (boiling point: 36°C), n-hexane (boiling point: 69°C), n-heptane (boiling point: 98°C), n-octane (boiling point: 126°C), n-nonane (boiling point: 151°C), n-decane (boiling point: 174°C), decalin (boiling point of the cis form: 196°C, boiling point of the trans form: 187°C), and bicyclohexyl (boiling point: 217°C to 233°C); aliphatic ketone solvents such as acetone (boiling point: 56°C), methyl ethyl ketone (boiling point: 80°C), methyl isobutyl ketone (boiling point: 117°C), cyclohexanone (boiling point: 156°C), 2-heptanone (boiling point: 150°C), 3-heptanone (boiling point measured at 765 mmHg: 147°C), 4-heptanone (boiling point: 144°C), 2-octanone (boiling point: 174°C), 2-nonanone (boiling point: 195°C), and 2-decanone (boiling point: 209°C); aromatic ketone solvents such as acetophenone (boiling point: 202°C); aliphatic ester solvents such as ethyl acetate (boiling point: 77°C) and butyl acetate (boiling point: 120°C to 125°C); aromatic ester solvents such as methyl benzoate (boiling point: 200°C), butyl benzoate (boiling point: 213°C), and phenyl acetate (boiling point: 196°C); aliphatic polyhydric alcohol solvents and solvents composed of a derivative of an aliphatic polyhydric alcohol, such as ethylene glycol (boiling point: 198°C), ethylene glycol monobutyl ether (boiling point: 171°C), ethylene glycol monoethyl ether (boiling point: 135°C), ethylene glycol monomethyl ether (boiling point: 125°C), 1,2-dimethoxyethane (boiling point: 85°C), propylene glycol (boiling points: 188°C), 1,2-diethoxymethane (boiling point: 124°C), triethylene glycol diethyl ether (boiling point: 222°C), and 2,5-hexanediol (boiling point: 218°C); aliphatic alcohol solvents such as methanol (boiling point: 65°C), ethanol (boiling point: 78°C), propanol (boiling point: 97°C), isopropanol (boiling point: 82°C), and cyclohexanol (boiling point: 161°C); aliphatic sulfoxide solvents such as dimethylsulfoxide (boiling point: 37°C); and aliphatic amide solvents such as N-methyl-2-pyrrolidone (boiling point: 202°C) and N,N-dimethylformamide (boiling point: 153°C).

After the step of preparing a supporting substrate 11 and before the step of supplying an ink, preferably, a lyophilic treatment is performed to the concave portion 18 defined by the partition wall. Thus, performing a lyophilic treatment facilitates wetting and spreading of the ink supplied to the concave portion 18 over the bottom plane of the concave portion 18, and therefore the treatment can prevent a hole from being formed on the organic EL layer. A lyophilic treatment may be performed by UV treatment or oxygen plasma treatment. Oxygen plasma treatment is preferred among these. This is because the oxygen plasma treatment is less likely to be accompanied by contamination of the organic EL element by an unintended impurity.

As described above, as a method for supplying an ink with ease and no defect to the concave portion 18 that is designed to have a stripe-pattern, the method for supplying an ink by discharging a liquid-columnar ink is suitable. Further, this method is particularly suitable for the method for supplying an ink that satisfies a concentration, a surface tension, a contact angle to the partition wall 17 and a viscosity as described in the above. That is, with regard to an ink jet printing method, when an ink satisfying the concentration, the surface tension, and the viscosity described above is used, clogging of a nozzle could occur in some cases, and therefore an ink having a low concentration is often used, resulting in using an ink having low surface tension and low viscosity. In this case, as described above, the ink supplied to the concave portion 18 could overflows the partition wall member 20 into an adjacent concave portion 18 in some cases. Therefore, when using an ink having a low concentration, an amount of the ink to be supplied is often increased, and a lyophobic treatment is often performed to the partition wall 17 for preventing the ink from overflowing the partition wall 17. However, performing a lyophobic treatment to the partition wall 17 leads to contamination by an unintended impurity during the treatment, and also leads to an increase in the number of steps, as described above. On the other hand, according to the method for supplying an ink to the concave portion 18 by discharging a liquid-columnar ink, it is not likely that clogging of a nozzle occurs, and therefore an ink satisfying the concentration, the surface tension and the viscosity described above can be supplied; furthermore, even when a contact angle between the ink and the partition wall 17 falls within the above range, by using an ink satisfying the concentration, the surface tension and the viscosity described above, the method can prevent the ink supplied to the concave portion 18 from overflowing the partition wall member 20 into an adjacent concave portion 18, and therefore an organic EL layer having an intended shape can be formed.

### <Composition of Organic EL Element>

An organic EL element 22 may have various layer structures, as described above. The layer structure of the organic EL element 22, the structure of each layer, and the method of forming each layer are explained below in further detail.

As described above, an organic EL element 22 has a pair of electrodes composed of an anode and a cathode (the first electrode 12 and the second electrode 16) and one or more organic EL layers interposed between the pair of electrodes, and has at least one light-emitting layer 14 as the organic EL layer. An organic EL element 22 may have a layer including both an inorganic substance and an organic substance, an inorganic layer, and the like. An organic Substance that constitutes the organic layer may be a low molecular compound, a macromolecular compound, or a mixture of a low molecular compound and a macromolecular compound. The organic layer preferably comprises a macromolecular compound, and preferably comprises a macromolecular compound having a number average molecular weight of 10³ to 10⁸ in terms of polystyrene.

The organic EL layer provided between a cathode and the light-emitting layer 14 may be an electron injection layer, an electron transport layer, a hole block layer, or the like. When both of the electron injection layer and the electron transport layer are provided between the cathode and the light-emitting layer 14, the layer closer to the cathode is called an electron injection layer, while the layer closer to the light-emitting layer is called an electron transport layer. An organic EL layer provided between an anode and the light-emitting layer 14 may be a hole injection layer, a hole transport layer, an electron block layer, or the like. When both of the hole injection layer and the hole transport layer are provided, the layer closer to the anode is called a hole injection layer, while the layer closer to the light-emitting layer 14 is called a hole transport layer.

Examples of the layer structures applicable to an organic EL element 22 of the present embodiment are indicated below.
a) anode / light-emitting layer / cathode
b) anode / hole injection layer / light-emitting layer /cathode
c) anode / hole injection layer / light emitting layer /electron injection layer / cathode
d) anode / hole injection layer / light-emitting layer /electron transport layer / cathode
e) anode / hole injection layer / light-emitting layer /electron transport layer / electron injection layer /cathode
f) anode / hole transport layer / light-emitting layer /cathode
g) anode / hole transport layer / light-emitting layer /electron injection layer / cathode
h) anode / hole transport layer / light-emitting layer /electron transport layer / cathode
i) anode / hole transport layer / light-emitting layer /electron transport layer / electron injection layer /cathode
j) anode / hole injection layer / hole transport layer /light-emitting layer / cathode
k) anode / hole injection layer / hole transport layer /light-emitting layer / electron injection layer / cathode
l) anode / hole injection layer / hole transport layer /light-emitting layer / electron transport layer / cathode
m) anode / hole injection layer / hole transport layer /light-emitting layer / electron transport layer / electron injection layer / cathode
n) anode / light-emitting layer / electron injection layer / cathode
o) anode / light-emitting layer / electron transport layer / cathode
p) anode / light-emitting layer / electron transport layer / electron injection layer / cathode
Here, the symbol "/" indicates that the layers at both sides of the symbol "/" are layered adjacent each other. The same applies to the description below.

An organic EL element 22 of the present embodiment may also have two or more light-emitting layers 14. With regard to any one of the above layer structures a) to p), when a stacked body interposed between an anode and a cathode is destined as "structure unit A", the structure of the organic EL element having two light-emitting layers may include a layer structure of q) indicated below. The layer structures of the two (structure unit A) may be the same or different from each other.
q) anode / (structure unit A) / charge generation layer /(structure unit A) / cathode
Further, when "(structure unit A) / charge generation layer" is defined as "structure unit B", a structure of the organic EL element having three or more light-emitting layers may include the layer structure of r) indicated below.
r) anode / (structure unit B)x / (structure unit A) /cathode
In this structure, a symbol "x" is an integer of two or more, and (structural unit B)x is a stacked body in which the structure unit B is stacked x times. A plurality of "structure unite-B"(s) may be the same or different from each other.

Here, the charge generation layer means a layer that generates holes and electrons when electric field is impressed thereto. Examples of the charge generation layer include a thin film made of vanadium oxide, indium tin oxide (ITO), molybdenum oxide, or the like.

In an organic EL element 22, the anode of a pair of electrodes composed of an anode and a cathode may be disposed closer to the supporting substrate 11 than the cathode and may be disposed on the supporting substrate 11, or the cathode may be disposed closer to the supporting substrate 11 than the anode and may be disposed on the supporting substrate 11. For example, in the above a) to r), each layer from the right end may be stacked in order on the supporting substrate 11 to constitute an organic EL element 22, or each layer from the left end may be stacked in order on the supporting substrate 11 to constitute an organic EL element 22. The order of the layers to be stacked, the number of the layers, and a thickness of each layer may be decided as appropriate by taking into consideration of luminous efficiency and the element life.

Next, a material for each layer that constitutes the organic EL element 22 and a method for forming the "layer are more specifically explained.

### <Anode>

When a structure is that light emitted from a light-emitting layer exits through an anode to the outside of an organic EL element, an electrode having light transparency is used as the anode. As the electrode having light transparency, a thin film of a metal oxide, a metal sulfide, a metal, or the like may be used. As the electrode having light transparency, those having high electric conductivity and high light transparency may preferably used. Specifically as the electrode having light transparency, a thin film made of indium oxide, zinc oxide, tin oxide, ITO, indium zinc oxide (IZO), gold, platinum, silver, copper, or the like may be used. Among these, a thin film made of ITO, IZO, or tin oxide is preferably used.
Examples of a method of making the anode may include a vacuum deposition method, a sputtering method, an ion plating method, and a plating method. As the anode, an organic transparent conductive film of a polyaniline or a derivative thereof, a polythiophene or a derivative thereof, or the like may be used.

A film thickness of the anode is appropriately designed in consideration of properties required, ease of a film formation step, and the like. A film thickness of the anode is, for example, 10 nm to 10 µm, is preferably 20 nm to 1 µm, and is further preferably 50 nm to 500 nm.

### <Cathode>

A material for a cathode preferably, has a small work function, facilitates electron injection into a light-emitting layer, and has high electric conductivity. In an organic EL element in which light is extracted from an anode, a material for the cathode preferably has high visible light reflectance because the cathode reflects light emitted from a light-emitting layer to the anode. As the material for the anode, the following may be used; an alkali metal, an alkaline-earth metal, a transition metal, a Group 13 metal in the periodic table, and the like. Examples of the material for the cathode to be used may include: metals such as lithium, sodium, potassium, rubidium, cesium, beryllium, magnesium, calcium, strontium, barium, aluminum, scandium, vanadium, zinc, yttrium, indium, cerium, samarium, europium, terbium, and ytterbium; alloys of two or more species of the above metals; alloys of one or more species of the above metals and one or more species from gold, silver, platinum, copper, manganese, titanium, cobalt, nickel, tungsten, and tin; and a graphite and a graphite intercalation compound. Examples of the alloy may include magnesium-silver alloys, magnesium-indium alloys, magnesium-aluminum alloys, indium-silver alloys, lithium-aluminum alloys, lithium-magnesium alloys, lithium-indium alloys, and calcium-aluminum alloys. As the cathode, a transparent conductive electrode made of a conductive metal oxide, a conductive organic substance, or the like may be used. Specific examples of the conductive metal oxide may include indium oxide, zinc oxide, tin oxide, ITO, and IZO, and examples of the conductive organic substance may include a polyaniline and derivatives thereof, and a polythiophene or derivatives thereof. The cathode may be a stacked body in which two or more layers are stacked. The electron injection layer may be used as the cathode.

A film thickness of the cathode is appropriately arranged in consideration of properties required, ease of the film formation step, and the like. A film thickness of the anode is, for example, 10 nm to 10 µm, is preferably 20 nm to 1 µm, and is further preferably 50 nm to 500 nm.

Examples of a method of making the cathode may include a vacuum deposition method, a sputtering method, and a lamination method by which a metal thin film is bonded in thermocompression bonding.

### <Hole Injection Layer>

Examples of a hole injection material for a hole injection layer may include oxides such as vanadium oxide, molybdenum oxide, ruthenium oxide, and aluminum oxide, phenylamine compounds, starburst-type amine compounds, phthalocyanine compounds, amorphous carbons, polyanilines, and polythiophene derivatives.

A film thickness of the hole injection layer is appropriately designed in consideration of properties required, ease of the film formation step, and the like. A film thickness of the hole injection layer is, for example, 1 nm to 1 µm, is preferably 2 nm to 500 nm, and is further preferably 5 nm to 200 nm.

### <Hole Transport Layer>

Examples of a hole transport material for the hole transport layer may include a polyvinylcarbazole or derivatives thereof, a polysilane or derivatives thereof, polysiloxane derivatives having an aromatic amine at a side chain or a main chain, pyrazoline derivatives, arylamine derivatives, stilbene derivatives, triphenyldiamine derivatives, a polyaniline or derivatives thereof, a polythiophene or derivatives thereof, a polyarylamine or derivatives thereof, a polypyrrole or derivatives thereof, poly(p-phenylene vinylene) or derivatives thereof, or poly(2,5-thienylene vinylene) or derivatives thereof.

A film thickness of the hole transport layer is designed in consideration of properties required, ease of the film formation step, and the like. A film thickness of the hole transport layer is, for example, 1 nm to 1 µm, is preferably 2 nm to 500 nm, and is further preferably 5 nm to 200 nm.

### <Light-Emitting Layer>

In general, a light-emitting layer is mainly made of an organic substance that emits any one of fluorescence and phosphorescence or both, or of the organic substance and a dopant assisting the organic substance. The dopant is added in order to improve luminous efficiency and change an emission wavelength, for example. The organic substance constituting the light-emitting layer may be a low molecular compound or a macromolecular compound, and in the case of forming a light-emitting layer by the coating method, the light-emitting layer preferably includes a macromolecular compound. The number average molecular weight of the macromolecular compound constituting the light-emitting layer is, for example, about 10³ to 10⁸ in terms of polystyrene. Examples of the light-emitting material for the light-emitting layer may include pigment materials, metal complex materials, polymer materials, and dopant materials, described below.

### (Pigment Material)

Examples of the pigment materials may include cyclopentamine derivatives, tetraphenyl butadiene derivative compounds, triphenylamine derivatives, oxadiazole derivatives, pyrazoloquinoline derivatives, distyrylbenzene derivatives, distyrylarylene derivatives, pyrrole derivatives, thiophene ring compounds, pyridine ring compounds, perinone derivatives, perylene derivatives, oligothiophene derivatives, oxadiazole dimers, pyrazoline dimers, quinacridone derivatives, and coumarin derivatives.

### (Metal Complex Material)

Examples of the metal complex materials may include metal complexes having as a central metal a rare-earth metal such as Tb, Eu, and Dy, or Al, Zn, Be, Ir, Pt, or the like, and having as a ligand a structure of oxadiazole, thiadiazole, phenylpyridine, phenylbenzimidazole, quinoline, or the like. Examples of the metal complex materials may include metal complexes that emit light from a triplet excited state such as iridium complexes and platinum, complexes, aluminum-quinolinol complexes, benzoquinolinol beryllium complexes, benzoxazolyl zinc complexes, benzothiazole zinc complexes, azomethyl zinc complexes, porphyrin zinc complexes, and phenanthroline europium complexes.

### (polymer Material)

Examples of the polymer materials may include polyparaphenylene vinylene derivatives, polythiophene derivatives, polyparaphenylene derivatives, polysilane derivatives, polyacetylene derivatives, polyfluorene derivatives, polyvinylcarbazole derivatives, and polymerized materials of the above pigment materials or the above metal complex materials.

A thickness of the light-emitting layer is usually about 2 nm to 200 nm.

### <Electron Transport Layer>

As an electron transport material for an electron transport layer, publicly known electron transport materials may be used. Examples of the electron transport material may include oxadiazole derivatives, anthraquinodimethanes or derivatives thereof, benzoquinones or derivatives thereof, naphthoquinones or derivatives thereof, anthraquinones or derivatives thereof, tetracyanoanthraquinodimethane or derivatives thereof, fluorenone derivatives, diphenyldicyanoethylene or derivatives thereof, diphenoquinone derivatives, metal complexes of 8-hydroxyquinoline or of derivatives of 8-hydroxyquinoline, polyquinolines or derivatives thereof, polyquinoxalines or derivatives thereof, or polyfluorenes or derivatives thereof.

A film thickness of the electron transport layer is appropriately designed in consideration of properties required, ease of the film formation step, and the like. A thickness of the electron transport layer is, for example, 1 nm to 1 µm, is preferably 2 nm to 500 nm, and is further preferably 5 nm to 200 nm.

### <Electron Injection Layer>

As a material for an electron injection layer, an optimum material is selected as appropriate depending on the species of a light-emitting layer. Examples of the material of the electron injection layer may include: alkali metals; alkaline-earth metals; alloys comprising one or more species of alkali metals and alkaline-earth metals; oxides, halides, and carbonates of alkali metals or alkaline-earth metals; or a mixture of these substances. Examples of the alkali metals, the oxides of alkali metals, the halides of alkali metals, and the carbonates of alkali metals may include lithium, sodium, potassium, rubidium, cesium, lithium oxides, lithium fluoride, sodium oxide, sodium fluoride, potassium oxide, potassium fluoride, rubidium oxide, rubidium fluoride, cesium oxide, cesium fluoride, and lithium carbonate. Examples of the alkaline-earth metals, the oxides of alkaline-earth metals, the halides of alkaline-earth metals, and the carbonates of alkaline-earth metals may include magnesium, calcium, barium, strontium, magnesium oxide, magnesium fluoride, calcium oxide, calcium fluoride, barium oxide, barium fluoride, strontium oxide, strontium fluoride, and magnesium carbonates. The electron injection layer may also be a stacked body in which two or more layers are stacked. Examples of the electron injection layer may include a stacked body of a LiF film and a Ca film.

A thickness of the electron injection layer is preferably about 1 nm to 1 µm.

When a plurality of organic EL layers capable of being formed by a coating method are included as the organic layer, although all the organic EL layers are preferably formed by a coating method, for example, at least one layer of the organic EL layers capable of being formed by a coating method may be formed by a coating method while the rest of other organic EL layers may be formed by a method other than the coating methods. When a plurality of organic EL layers are formed by a coating method, the organic EL layers may be formed by coating methods that are different from each other in specific processes. For example, it has been explained in the present embodiment that the hole injection layer 13 and the light-emitting layer 14 are formed by a nozzle coating method. However, it is possible to form the hole injection layer 13 by a spin coating method while forming the light-emitting layer 14 by a nozzle printing method. Examples of the method, other than the coating methods, that may be used to form an organic EL layer may include a vacuum deposition method, a sputtering method, a lamination method, and a spray coating method.

### Examples

A light-emitting device having substantially the same structure as of the light-emitting devices that are schematically illustrated in Figures 1 and 2 was manufactured. The organic EL element manufactured in this example further includes an interlayer between a hole injection layer and a light-emitting layer.

First, a supporting substrate on which an anode and an insulating film were formed was prepared. The supporting substrate was made of a glass plate; the anode was made of an ITO thin film; and the insulating film was made of an SiO₂ film. The film thicknesses of the anode and the insulating film were each 200 nm. The insulating film had a rectangular opening formed therein so as to expose part of the ITO thin film, and the size of the opening was 200 µm in the line direction X and 70 µm in the column direction Y.

Then, stripe-pattern partition wall members were formed. First, a positive photosensitive material OFPR-800 (manufactured by TOKYO OHKA KOGYO CO., LTD.) was applied by a spin coating method to all over the supporting substrate on which the anode and the insulating film were formed to form a thin film, having a film thickness of 2 µm, Then, exposure was performed using a photomask that is designed to have a width of partition wall members in the column direction Y of 20 µm and a distance (cycle) between partition wall members of 100 µm, followed by development with an alkaline developer solution (NMD-3: manufactured by TOKYO OHKA KOGYO CO., LTD.). Thermosetting treatment was then carried out at 230°C for 30 minutes to complete insolubilization, thereby forming a partition wall member. The capacity of a concave portion that was defined by the partition wall member was 1.63 x 10⁻¹⁰m³ per unit length in the line direction X.

Next, oxygen plasma treatment was performed on the supporting substrate on which the anode, the insulating film, and the partition wall were formed, before ink application. Oxygen plasma treatment was performed for 30 seconds by RIE-200L manufactured by SAMCO INC. by introducing oxygen gas under a condition of 5 Pa, 40 SCCM, and 30 W.

Then, a PEDOT film was formed as a hole injection layer. First, CLEVIOS P VP CH8000 manufactured by H. C. Starck Ltd. and deionized water were mixed to achieve a volume ratio of 40:60 to prepare an ink. The surface tension of the ink was 70 mN/m and the viscosity was 6.3 cP. The contact angle of the ink to the partition wall was 40 degrees. The ink thus prepared was applied to each concave portion using a nozzle printing device (NP-300G manufactured by DAINIPPON SCREEN MFG. CO., LTD.) under the conditions of the flow rate of 78 µL/min and the nozzle operation rate of 2.5 m/s. Subsequently, by heating in the clean oven (DT610 manufactured by Yamato Scientific Co., Ltd.) in an atmospheric environment at 200°C for 20 minutes, a hole injection layer was formed.

Then, an interlayer was formed. First, a polymer material of an interlayer was added to a mixed solvent of guaranteed reagent-grade anisole and guaranteed reagent-grade phenylcyclohexane manufactured by Wako Pure Chemical Industries, Ltd. at. 1:1 (in volume ratio), at a concentration of 10 mg/mL, and the resultant was heated with stirring at 50°C for 10 hours to prepare an ink for forming an interlayer. The surface tension of the ink was 34 mN/m and the viscosity of the ink was 4.5 cP. The contact angle of the ink to the partition wall was 15 degrees. The ink thus prepared was applied to each concave portion using a nozzle printing device (NP-300G manufactured by DAINIPPON SCREEN MFG. CO., LTD.) under the conditions of the flow rate of 26 µL/min and the nozzle operation rate of 3.0 m/s. Subsequently, by heating with a hot plate (HP-1LA manufactured by As One Corporation) in a nitrogen atmosphere at 180°C for 60 minutes, an interlayer was formed.

Then, a light-emitting layer was formed. First, each of a blue light-emitting polymer material, a green light-emitting polymer material, and a red light-emitting polymer material was added to a mixed solvent of guaranteed reagent-grade anisole and guaranteed reagent-grade phenylcyclohexane manufactured by Wako Pure Chemical Industries, Ltd. at 1:1 (in volume ratio), at a concentration of 20 mg/mL, and the resultant was heated with stirring at 50°C for 10 hours to prepare an ink for forming a light-emitting layer. The surface tensions of the blue ink, the green ink, and the red ink were each 34 mN/m, the viscosity of the blue ink was 26 cP, the viscosity of the green ink was 20 cP, and the viscosity of the red ink was 24 cP. The contact angles of the blue ink, the green ink or the red ink to the partition wall, all of which were 15 degrees.

The red ink, the blue ink, and the green ink thus prepared, each was supplied to the concave portion by providing the interval of two lines. For supplying ink, the nozzle printing device (NP-300G manufactured by DAINIPPON SCREEN MFG. CO., LTD.) was used, and the ink was supplied by applying in the order of the blue ink, the green ink, and the red ink. The condition of blue ink application was the flow rate of 26 µL/min and the nozzle operation rate of 2.6 m/s. The condition in green ink application was the flow rate of 30 µL/min and the nozzle operation rate of 2.6 m/s. The condition in red ink application was the flow rate of 36 µL/min and the nozzle operation rate of 3.0 m/s. Subsequently, by heating with the hot plate (HP-1LA manufactured by As One Corporation) in a nitrogen atmosphere at 130°C for 15 minutes, a light-emitting-layer was formed.
Deposition was then performed so as to obtain the film thickness of Ba of 5 nm, and further deposition was performed so as to obtain the film thickness of Al of 100 nm, thereby forming a cathode.

The amounts of the red ink, the green ink, and the blue ink supplied, each was changed to manufacture a plurality of the above described light-emitting devices. The amount of the ink to be supplied was adjusted by controlling the amount of the ink to be discharged per unit time and/or the nozzle operation rate.

After supplying the ink by changing the amount of the ink to be supplied to the concave portion and then solidifying the resultant to obtain a plurality of samples, the surfaces of the samples were observed by the fluorescence microscope (ECLIPSE E800 manufactured by NIKON CORPORATION) to evaluate film formation.

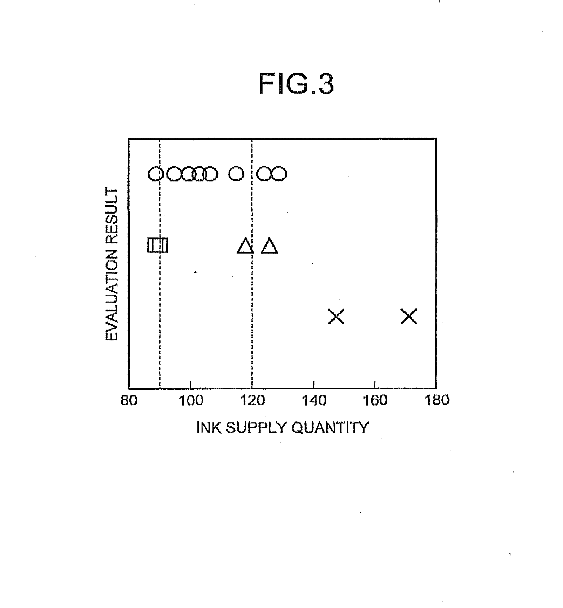

Figure 3 is a view illustrating the evaluation results. The abscissa indicates the amount of the ink supplied as a proportion of the volume of the ink supplied relative to the capacity of the concave portion. The ordinate indicates the evaluation results. In the evaluation results, a sample that is highly evaluated is indicated at a higher position, while samples that have similar evaluation results are indicated at a similar height. In Figure 3, a sample in which the film formation having an intended organic EL layer was obtained is indicated by the symbol "o", a sample in which the ink did not completely wet and spread over the bottom plane of the concave portion and a hole was formed in part of the organic EL layer is indicated by the symbol "□", a sample in which the ink did not overflow into the adjacent concave portion while the organic EL layer was also formed on the partition wall is indicated by the symbol "Δ", and a sample in which the ink overflowed the partition wall into the adjacent concave portion is indicated by the symbol "x".

### EXPLANATIONS OF LETTERS OR NUMERALS

- 1, 17: partition wall 2, 18 concave portion
- 3: organic EL layer
- 11: supporting substrate
- 12: first electrode (anode)
- 13: hole injection layer
- 14: light-emitting layer
- 15.: insulating film
- 15a: opening
- 16: second electrode (cathode)
- 20: partition wall member
- 21: light-emitting device
- 22: organic EL element

## Claims

1. A method for manufacturing a light-emitting device comprising a supporting substrate, a partition wall that is provided on the supporting substrate and defines a concave portion, a plurality of organic electroluminescent elements provided in the concave portion, each element comprising a first electrode, a second electrode, and an organic electroluminescent layer provided between the first electrode and the second electrode, the method comprising the steps of:
preparing the supporting substrate that is provided with the first electrode and the partition wall;
supplying an ink that comprises a material to be the organic electroluminescent layer to the concave portion, so as to be the volume of 90 percent or more and 120 percent or less relative to a capacity of the concave portion;
forming the organic electroluminescent layer by solidifying the supplied ink; and
forming the second electrode.

2. The method for manufacturing the light-emitting device according to claim 1,
wherein the partition wall comprises a plurality of partition wall members extending in a line direction, respectively, and each of the partition wall members is disposed to a column direction different from the line direction at a prescribed interval.

3. The method for manufacturing the light-emitting device according to claim. 1,
wherein a viscosity of the ink is 15 cP or more and 30 cP or less.

4. The method for manufacturing the light-emitting device according to claim 1,
wherein a concentration of the ink is 10 mg/mL or more and 30 mg/mL or less.

5. The method for manufacturing the light-emitting device according to claim 1,
wherein a contact angle between the partition wall and the ink is 5 degrees or more and 50 degrees or less.

6. The method for manufacturing the light-emitting device according to claim 5,
wherein an oxygen plasma treatment is carried out after the step of preparing the support substrate, and before the step of supplying the ink.

7. The method for manufacturing the light-emitting device according to claim 1,
wherein a surface tension of the ink is 30 mN/m or more and 72 mN/m or less.

8. The method for manufacturing the light-emitting device according to claim 1,
wherein the ink comprises a solvent that has a boiling point of 190 degrees Celsius or more and 260 degrees Celsius or less.

9. The method for manufacturing the light-emitting device according to claim 1,
wherein, at the step of supplying, the ink is dropped in a liquid-column shape.

10. The method for manufacturing the light-emitting device according to claim 1,
wherein, at the step of supplying, the ink is supplied by a nozzle printing method.
